# EUROPÄISCHE PATENTSCHRIFT

(11) **EP 0 503 106 B1**
(45) Veröffentlichungstag und Bekanntmachung des Hinweises auf die Patenterteilung: **30.08.1995**
(21) Anmeldenummer: 91103615.0
(22) Anmeldetag: 08.03.1991
(51) Int. Cl.: H05K 9/00

(54) **Geschirmte Kabine in Modulbauweise**
Shielded room made of module construction
Chambre blindée construite d'assemblage de modules

(43) Veröffentlichungstag der Anmeldung: 16.09.1992
(73) Patentinhaber: SIEMENS MATSUSHITA COMPONENTS GmbH & CO KG, 81541 München (DE)
(72) Erfinder: Stabenow, Jürgen, Dipl.-Ing., W-7920 Heidenheim (DE); Stelzl, Gerhard, Dipl.-Ing., W-7920 Heidenheim (DE); Trautnitz, Friedrich-Wilhelm, Dipl.-Ing., W-7922 Herbrechtingen (DE)
(74) Vertreter: Fuchs, Franz-Josef, Dr.-Ing.

(56) Entgegenhaltungen:
- DE-A- 3 209 349
- DE-U- 8 410 203
- US-A- 3 217 085

## Beschreibung

### Schirmungsmodul für eine geschirmte Kabine in Modulbauweise

Die Erfindung betrifft einen Schirmungsmodul für eine geschirmte Kabine in Modulbauweise nach dem Oberbegriff des Patentanspruchs 1.

Ein derartiges Schirmungsmodul ist aus der DE 32 09 349 C2 bekannt. Die Schirmungsmodule sind als Profilrahmen ausgebildet und mit vorgefertigten, im Baukastenprinzip zu elektromagnetisch abgeschirmten Räumen zusammengesetzten Normalfeldern lückenlos verschweißt. Die Verbindungsfugen sind dabei durch Kontaktfedern aus ferromagnetischem Material zugefüllt.

Die Schwierigkeiten, die bei der bekannten Abschirmung auftreten können, bestehen darin, daß die erforderlichen Schweißnähte einen Schwachpunkt in der Abschirmung darstellen, wenn sie nicht ordnungsgemäß ausgeführt sind. Da diese Schweißnähte großflächig angeordnet sind, besteht die Gefahr, daß durch Spannungen, die durch Temperaturgänge hervorgerufen werden können, die Schweißnähte an einzelnen Stellen aufplatzen können, so daß der Abschirmungseffekt wesentlich verringert wird. Diese Gefahr ist insbesondere dann relevant, wenn diese Schwachstellen erst im Laufe der Betriebszeit auftreten, da ein gerade fertig gestellter geschirmter Raum im allgemeinen ausgemessen wird, bevor er in Betrieb genommen wird. Da diese Ausmessungen auf Schirmdichtheit nicht ständig wiederholt werden können, sind die latenten Gefahren durch unvollständige Schweißnähte nicht erwünscht.

Ferner ist aus der US 3 217 085 eine geschirmte Kabine bekannt, die aus vorgefertigten Schirmungsmodulen aufgebaut ist. Die Schirmungsmodule weisen in ihren Verbindungsbereichen rechtwinklig abgebogene Ausformungen auf. Zur Montage der Kabine sind hierbei zusätzliche Verbindungselemente erforderlich, wodurch die Montage erschwert wird.

Aufgabe der vorliegenden Erfindung ist es, einen Schirmungsmodul für eine geschirmte Kabine in Modulbauweise anzugeben,der eine gute Abschirmung gewährleistet und eine preisgünstige Herstellung und Montage einer geschirmten Kabine ermöglicht.

Diese Aufgabe wird durch die im Patentanspruch 1 angegebenen Merkmale gelöst.

Vorteilhafte Ausgestaltungen bestehen darin, daß das verzinkte Stahlblech eine Dicke von 2 mm besitzt, daß der Verbindungsbereich eine Breite von 50 mm aufweist, und daß im Verbindungsbereich eine Lochteilung mit 75 mm Rastermaß mit einem Einstiegsmaß von 37 mm angeordnet ist.

Zweckmäßigerweise weisen die Schirmungsmodule für die Eckenanbindung Eckfelder auf, die um das Maß für den Verbindungsbereich, also vorzugsweise 50 mm, verbreitert sind.

Durch die geschilderte Ausgestaltung ergeben sich Standardmodulbreiten und Längenmaße von 300, 600, 900, 1200 und 1500 mm für Seiten-, Boden- und Deckenmodule bzw. 2550 mm für die Standardhöhe I und 3000 mm für die Standardhöhe II.

Weitere vorteilhafte Ausgestaltungen sind in weiteren abhängigen Unteransprüchen angeführt.

Die Erfindung wird anhand von Ausführungsbeispielen näher erläutert.

In der dazugehörigen Zeichnung zeigen
FIG 1 die Ansicht einer Modulkabine,
FIG 2 einen Schnitt durch den verschraubten Verbindungsbereich zweier Schirmungsmodule,
FIG 3 die Teilansicht eines normalen Seitenfeld-Verbindungsbereiches,
FIG 4 die Teilansicht eines Verbindungsbereiches für eine Ecke,
FIG 5 die geschnittene Ansicht eines Dichtungsmeshs für die Modulfugen,
FIG 6 ein schematischer Schnitt durch verschiedene Modulkonfigurationen in Seitenansicht,
FIG 7 ein Schnittbild des Anschlußpunktes eines Platteneinsatzes einer Modulkabine,
FIG 8 ein Schnittbild durch den Anschluß eines Filters an eine Modulkabine,
FIG 9 ein Schnittbild durch den Anschluß eines weiteren Filters an eine Modulkabine,
FIG 10 ein Schnittbild durch den Anschlußpunkt einer Rohrdurchführung an eine Modulkabine,
FIG 11 ein Schnittbild durch den Anschlußpunkt einer weiteren Rohrdurchführung an eine Modulkabine,
FIG 12 die Ansicht eines verstärkten Modulkreuzungspunkts,
FIG 13 ein Schnittbild durch einen verstärkten Kreuzungspunkt einer Modulkabine und
FIG 14 und 15 Schnittbilder durch einen Haltestöpsel als Montagehilfe für den Aufbau einer Modulkabine.

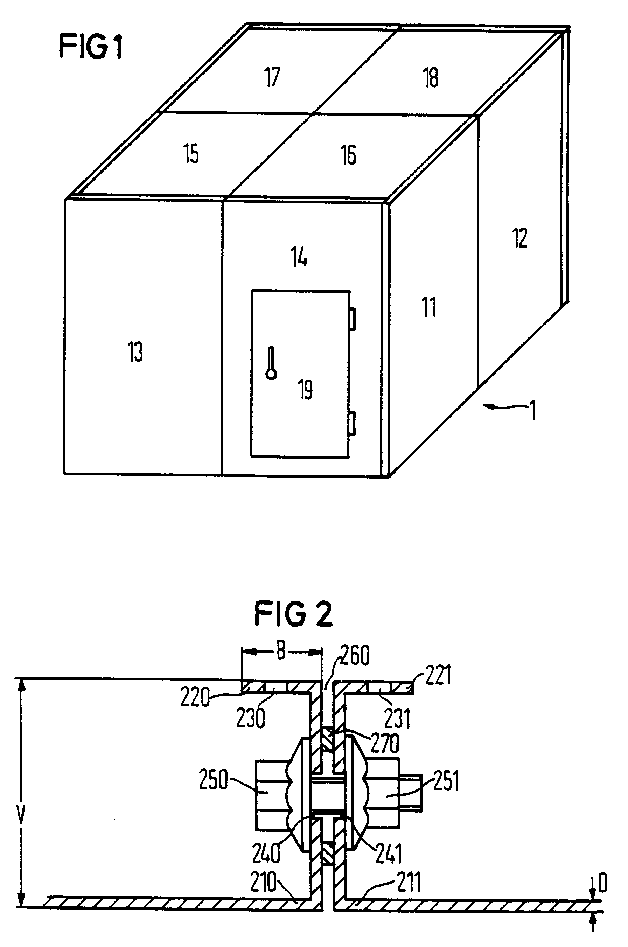

In der FIG 1 ist die Außenansicht einer aus einzelnen vorgefertigten Schirmungsmodulen aufgebauten geschirmten Kabine 1 dargestellt. Die Kabine 1 besteht aus einzelnen Feldern, von denen in der FIG 1 die Seitenfelder 11, 12, 13, 14 und die Deckenfelder 15, 16, 17, 18 sichtbar sind. Im Seitenfeld 14 ist eine hochfrequenzdicht abgeschirmte Eingangstür 19 angeordnet.

Die in der FIG dargestellten Einzelfelder können wiederum aus einzelnen Schirmungsmodulen zusammengesetzt sein.

In der FIG 2 ist der Schnitt durch die Verschraubung zweier Schirmungsmodule 210, 211 im Verschraubungsbereich V dargestellt. Der FIG ist zu entnehmen, daß der Verschraubungsbereich V an die Schirmungsmodule 210, 211 einstückig angeformt ist und die Form eines U besitzt, dessen einer Schenkel 220, 221 verkürzt ist. Der verkürzte Schenkel 220, 221 dient als Versteifungssteg, der vorzugsweise Bohrungen 230, 231 aufweist, die zur einfachen und kostengünstigen Befestigung des Innenausbaus wie Wandverkleidung, Absorberausstattung, Elektroinstallation, o.dgl. dienen. Im Verbindungsbereich V sind Löcher 240, 241 angeordnet, die zur Verbindung der Schirmungsmodule 210, 211 mittels einer Sperrzahnschraube 250 und dazugehörender Sperrzahnmutter 251 dienen.

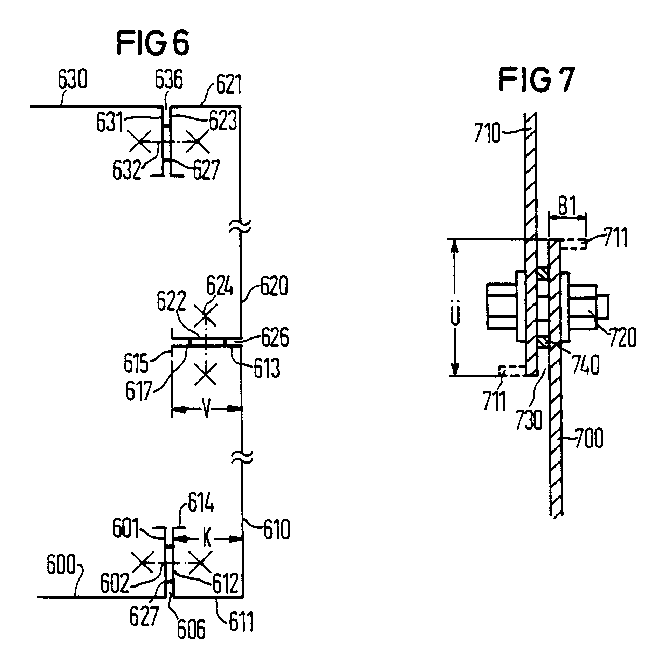

Die Verbindungsfuge 260 zwischen den Schirmungsmodulen 210, 211 ist hochfrequenzdicht durch ein in der FIG 5 dargestelltes Dichtungsmesh 270 abgedichtet.

Die Schirmungsmodule 210, 211 bestehen aus verzinktem Stahlblech, das eine Dicke D von 2 mm besitzt. Der Verbindungsbereich V ist 50 mm breit, während die Versteifungsstege 220, 221 eine Breite B von 15 mm aufweisen. Die Löcher 240, 241 im Verbindungsbereich V der Schirmungsmodule 210, 211 sind mit einem Rastermaß von 75 mm und einem Einstiegsmaß von 37 mm angeordnet.

Im Fall von lackierten Schirmelementen werden anstelle der in der FIG 2 dargestellten Sperrzahnschrauben und -muttern (M10) Schneidschrauben verwendet.

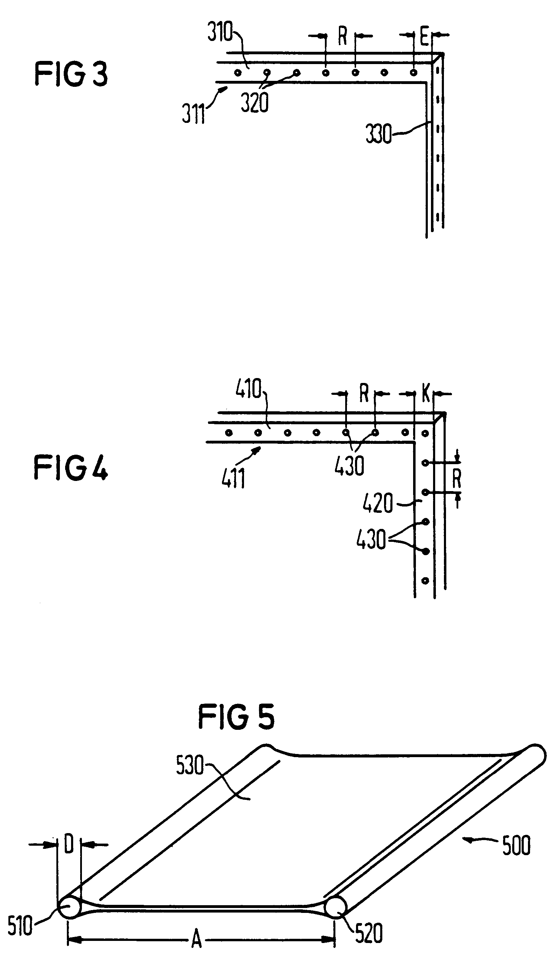

In der FIG 3 ist die Teilansicht auf den Verbindungsbereich 310 eines Seitenfeldes 311 dargestellt. Die Bohrungen 320 sind im Rastermaß R von 75 mm angeordnet, während das Einstiegsmaß E 37 mm beträgt. Die schmale Leiste 330 dient zur Verbindung mit beispielsweise einem weiteren Seitenfeld.

In der FIG 4 ist die Ansicht der Verbindungsfuge 410 eines Eckfeldes 411 dargestellt. Der Verbindungsbereich 410 des Eckfeldes ist um die Kantung K von 50 mm breiter (K = Verbindungsbereich), so daß ein zusätzlicher Verbindungsbereich 420 entsteht, der ebenfalls mit Bohrungen 430 versehen ist, die im Abstand des Rastermaßes R angeordnet sind.

In der FIG 5 ist in perspektivischer Ansicht der Schnitt durch ein Dichtungsmesh 500 dargestellt, das im Verbindungsbereich zweier Schirmungsmodule zur Abschirmung der Verbindungsfugen angeordnet wird. Das Dichtungsmesh besteht aus zwei voll metallischen, gewebten Dichtschnüren 510, 520, die mittels eines Verbindungsgeflechts 530 miteinander verbunden sind. Die Dichtungsschnüre 510, 520 haben einen Durchmesser von 2 bis 4 mm und sind in einem Abstand A von 25 mm angeordnet. Das Dichtungsmesh 500 wird in den Verbindungsfugen derart angeordnet, daß die Dichtungsschnüre 510, 520 ungefähr beidseitig der im Rastermaß angeordneten Bohrungen liegen, so daß die Verschraubung ungefähr in der Mitte des Verbindungsgeflechts 530 erfolgt.

In der FIG 6 ist schematisch in Seitenansicht ein Schnitt durch verschiedene Modulkonfigurationen dargestellt. Ein Bodenfeld 600 ist mit einem Seitenfeld 610 verbunden. Das Seitenfeld 610 ist in seinem unteren Ende 611 als Eckverbindungsfeld ausgeführt, so daß die zusätzliche Kantung K entsteht, deren Größe der Breite V der Verbindungsbereiche 612, 613 entspricht. Am Ende der Verbindungsbereiche 612, 613 sind Versteifungsstege 614, 615 angeordnet.

Das Seitenfeld 610 ist an seinem oberen Ende mit einem weiteren Seitenfeld 620 mit Eckenbereich 621 im Verbindungsbereich 622 verschraubt. An das Seitenfeld 620 schließt sich ein Deckenfeld 630 an, dessen Verbindungsbereich 631 mit dem Verbindungsbereich 623 des Seitenfeldes 620 verbunden ist. Das Bodenfeld 600 ist mit dem Seitenfeld 610 über die Verbindungsbereiche 601, 612 verbunden.

In den einzelnen Verbindungsbereichen erfolgt die in der FIG 2 näher erläuterte Verschraubung 602, 624, 632. Die Verbindungsfugen 606, 626, 636 sind durch die Verbindungsmeshs 607, 617, 627 abgedichtet.

Aus der FIG 6 ist der Aufbau einer geschirmten Kabine in Modulbauweise ersichtlich, wobei der Aufbau vom Inneren der Kabine her erfolgt.

In der FIG 7 ist das Schnittbild durch den Anschlußpunkt eines Platteneinsatzes 700 im Schirmungsmodul 710 dargestellt. Derartige Platteneinsätze dienen dazu, nur zeitweise benötigte Öffnungen in den Wänden geschirmter Räume (z. B. Durchreichen) hochfrequenzdicht zu verschließen. Platteneinsatz 700 und Schirmungsmodul 710 werden im Überlappungsbereich Ü (ca. 50 mm) mittels der Sperrzahnschraube (M10) mit Mutter 720 miteinander verbunden. Die Verbindungsfuge 730 wird wie bereits geschildert, durch das Dichtungsmesh 740 abgedichtet. Platteneinsatz 700 und Schirmungsmodul 710 können Versteifungskanten 701, 711 aufweisen, deren Breite z. B. ca. 15 mm betragen kann.

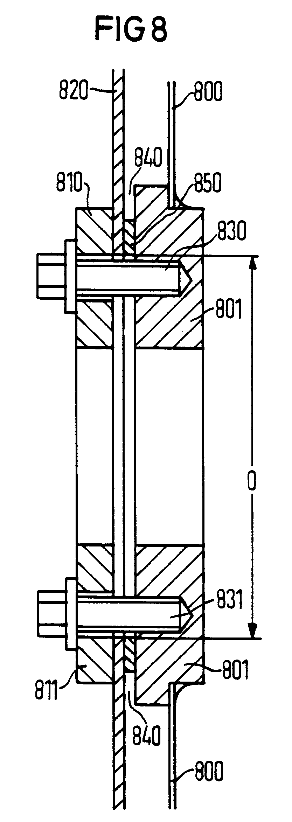

In der FIG 8 ist das Schnittbild durch den Anschluß eines Filters an eine Modulkabine dargestellt. Das Filtergehäuse 800 ist mit einem angeschweißten Flansch 801 versehen und mittels der losen Gegenflansche 810, 811 mit dem Schirmungsmodul 820 durch die Schrauben mit Sicherungsscheibe 830, 831 verbunden. Die Fuge 840 zwischen dem Flansch 801 und dem Schirmungsmodul 820 ist durch einen geschlossenen Meshdichtungsring 850 abgedichtet. Zum Einsatz des Filters weist der Schirmungsmodul 820 einen Bohrungsdurchmesser 0 auf. Die Befestigungsschrauben 830, 831 liegen innerhalb des Bohrungsdurchmessers 0. Dadurch läßt sich das Filter in einem beliebigen Winkel anschrauben.

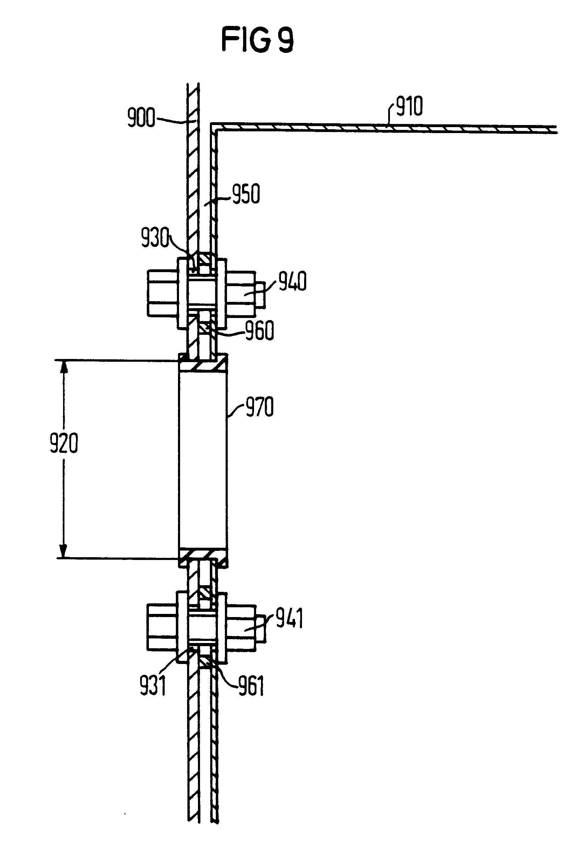

In der FIG 9 ist das Schnittbild des Anschlusses eines weiteren Filters an eine Modulkabine dargestellt. Sowohl Schirmungsmodul 900 als auch Filtergehäuse 910 weisen eine Bohrung gleichen Durchmessers 920 auf. Weiter sind im Schirmungsmodul 900 und im Filtergehäuse 910 Bohrungen 930, 931 für die Verschraubung des Filtergehäuses 910 mittels der Sperrzahnschrauben und Muttern 940, 941 vorgesehen. Die Verbindungsfuge 950 zwischen Schirmungsmodul 900 und Filtergehäuse 910 ist im Bereich der Verschraubungen durch die Dichtungsmeshs 960, 961 abgedichtet. Im Bereich der Bohrung 920 ist ein Gummiring 970 zum Schutz der Kabel gegen Aufscheuern angeordnet.

Bei dünnen Filtergehäusen 910 ohne ausreichende Bodensteifigkeit kann im Filterinnern ein loser Gegenflansch Verwendung finden.

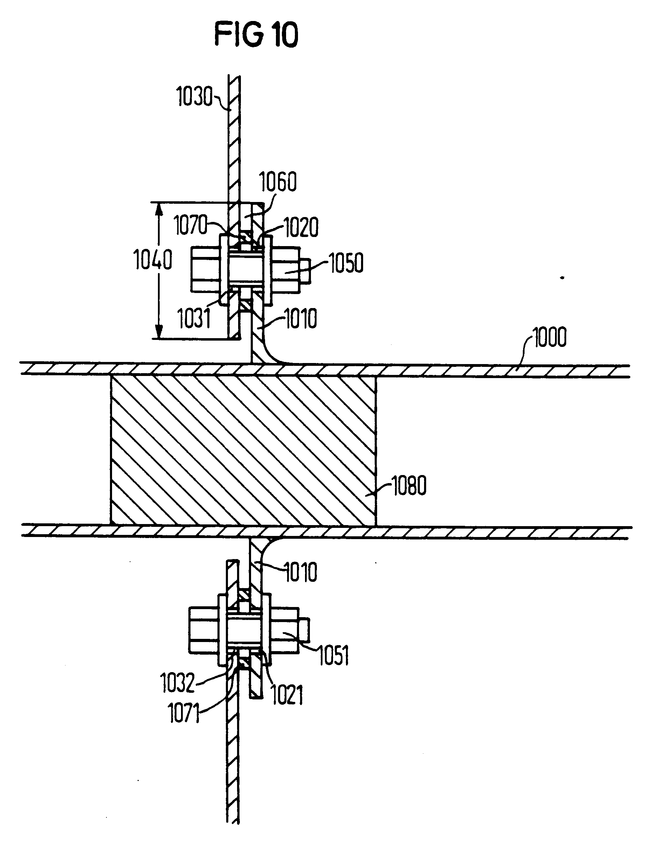

In der FIG 10 ist der Schnitt durch den Anschlußpunkt einer Rohrdurchführung an eine Modulkabine dargestellt. Das Rohr 1000 besitzt einen angeschweißten Flansch 1010 in dem Bohrungen 1020, 1021 angeordnet sind. Der Schirmungsmodul 1030 weist ebenfalls Bohrungen 1031, 1032 auf und wird mit der Überlappung 1040 (ca. 50 mm) durch Sperrzahnschrauben (M10) mit Muttern 1050, 1051 mit dem Rohr 1000 verschraubt. Die Dichtungsfuge 1060 zwischen Flansch 1010 und Schirmungsmodul 1030 wird im Bereich der Verschraubung durch die Dichtungsmeshs 1070, 1071 abgedichtet. Im Rohr 1000 ist ein Wabenkamin 1080 angeordnet, der hochfrequenzdicht mit dem Rohr 1000 verbunden ist.

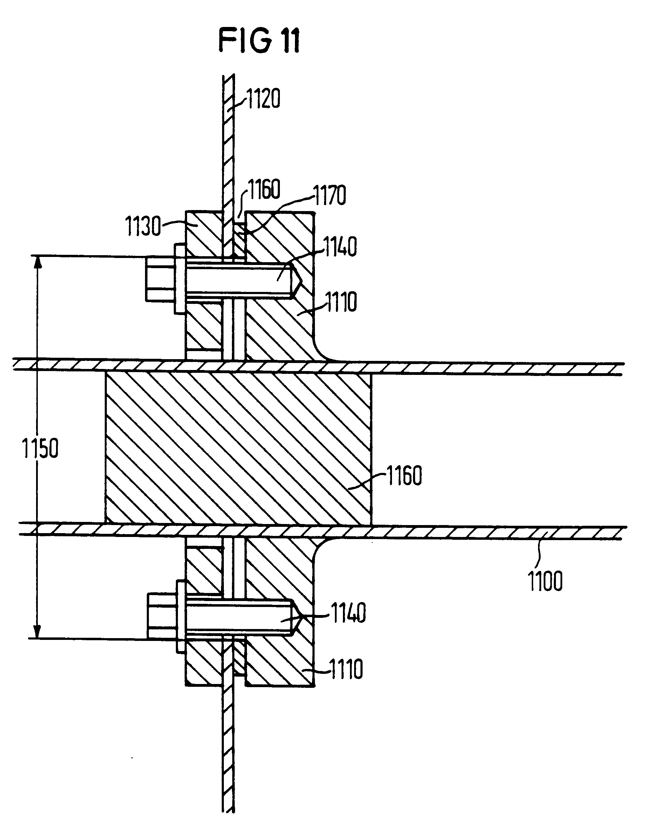

In der FIG 11 ist der Schnitt durch den Anschlußpunkt einer weiteren Rohrdurchführung an eine Modulkabine dargestellt. Das Rohr 1100 besitzt einen angeschweißten Flansch 1110 und ist mit dem Schirmungsmodul 1120 mittels des losen Gegenflansches 1130 und der Verschraubung 1140 verbunden. Im Schirmungsmodul 1120 ist hierfür eine Bohrung 1150 angebracht. Die Verbindungsfuge 1160 zwischen Schirmungsmodul 1120 und Flansch 1110 ist durch den geschlossenen Meshdichtungsring 1170 abgedichtet. Die Befestigungsverschraubung 1140 liegt innerhalb der Bohrung 1150. Dadurch läßt sich die Rohrdurchführung in einem beliebigen Winkel anschrauben.

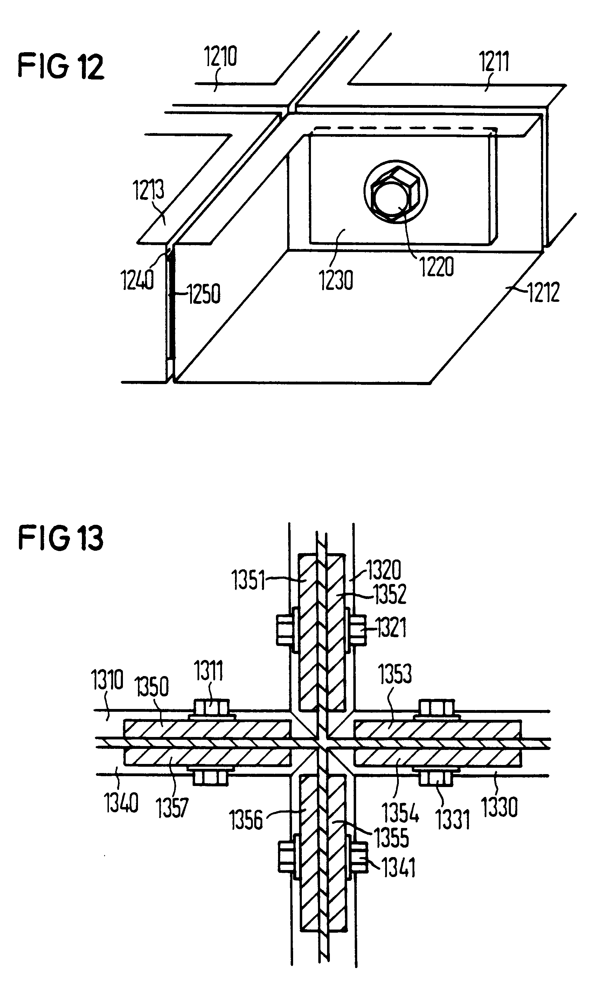

In der FIG 12 ist die Ansicht eines Modulkreuzungspunktes mit Verstärkungselement dargestellt. Vier Schirmungsmodule 1210, 1211, 1212, 1213 sind durch Modulschrauben 1220 miteinander verbunden, wobei zwischen Schraube 1220 und Schirmungsmodul 1212 ein Verstärkungselement 1230 angeordnet ist. In der FIG ist nur ein Verstärkungselement und eine Verschraubung dargestellt. In den Verbindungsfugen 1240 ist ein hochfrequenzdichtes Kontaktmaterial 1250 angeordnet.

FIG 13 zeigt den Schnitt durch einen Kreuzungspunkt einer Modulkabine zur Lagedarstellung aller Verstärkungselemente des Kreuzungspunktes. Die einzelnen Schirmungsmodule 1310, 1320, 1330 und 1340 sind durch die Schrauben 1311, 1321, 1331 und 1341 miteinander verbunden. Im Verschraubungsbereich sind Verstärkungselemente 1350, 1351, 1352, 1353, 1354, 1355, 1356 und 1357 angeordnet. Durch den Einbau dieser Verstärkungselemente 1350 bis 1357 ausreichender Härte wird speziell im Moduleckenbereich eine wesentlich bessere Kraftverteilung auf das Kontaktmaterial erzielt. Mit den Verstärkungselementen 1350 bis 1357 lassen sich Anpreßdrücke auf das Kontaktmaterial in der Fuge erzeugen, die - bedingt durch die Materialstärke der Modulaufkantung - über dem bisher möglichen liegen. Durch die homogenere Kraftverteilung erleichtert sich zusätzlich die Modulausrichtung bei der Montage. Die Verbindungsschrauben 1311, 1321, 1331, 1341 mit den Verstärkungselementen 1350 bis 1357 können zum Ausrichten der Schirmungsmodule 1310, 1320, 1330, 1340 verwendet werden. Ohne die Verstärkungselemente 1350 bis 1357 würden die Module 1310, 1320, 1330, 1340 an den Bohrungen durch die große Krafteinwirkung auf einzelne Schrauben 1311, 1321, 1331, 1341 ausgewölbt werden.

Bei Dichtheitsproblemen im Bereich einer laufenden Fuge ist durch den nachträglichen Einbau von Verstärkungselementen eine "Reperatur" durch Erhöhung des Kontaktdrucks möglich, wobei die Ortung der Leckstellen mit Feldsonden möglich ist.

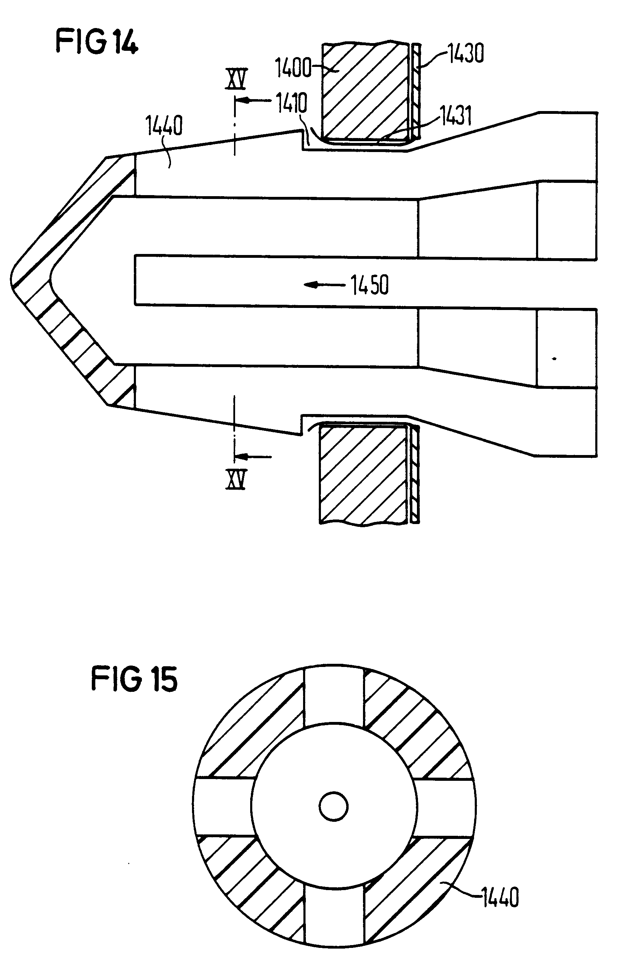

In den FIG 14 und 15 sind ein Längs- und ein Querschnitt durch eine Montagehilfe für den Aufbau einer Modulkabine dargestellt. Der Schirmungsmodul 1400 weist die Bohrung 1410 auf, bei der die Verschraubung mit einem weiteren Modul erfolgt. Vor der Verbindung zweier Module wird das in der Verbindungsfuge angeordnete Dichtungsmesh 1430 durch einen Haltestöpsel 1440 festgelegt. Hierbei werden einzelne Fäden 1431 des Verbindungsgeflechtes zwischen Stöpsel 1440 und Schirmmodul 1400 eingeklemmt. Das in der FIG 14 dargestellte Dichtungsmesh 1430 entspricht dem Verbindungsgeflecht 530 der FIG 5. Nachdem das Dichtungsmesh 1430 im gesamten Verbindungsbereich des Schirmmoduls 1400 durch Haltestöpsel 1440 festgelegt ist, erfolgt der Zusammenbau mit einem weiteren Modul, wobei der Haltestöpsel 1440 in Einsteckrichtung 1450 aus der Bohrung 1410 herausgedrückt wird.

Der Haltestöpsel 1440 ist mehrfach verwendbar.

Die in den Ausführungsbeispielen geschilderte geschirmte Kabine in Modulbauweise ist für den Frequenzbereich von 1kHz bis 40 GHz einsatzfähig.

## Patentansprüche

1. Schirmungsmodul aus verzinktem Stahlblech für eine geschirmte Kabine (1) in Modulbauweise, die aus einzelnen vorgefertigten Schirmungsmodulen (210, 211, 600, 610, 620, 630) besteht, die hochfrequenzdicht miteinander verschraubt werden, wobei der Schirmungsmodul (210, 211, 600, 610, 620, 630) im Verbindungsbereich (V, 601, 612, 613, 622, 623, 631) die Form eines U besitzt, dessen einer Schenkel (220, 221, 614, 615) verkürzt ist,
**dadurch gekennzeichnet,**
daß der Verbindungsbereich (V 601, 612, 622, 623, 631) an den Schirmungsmodul einstückig angeformt ist, und daß im verkürzten U-Schenkel (220, 221) Bohrungen (230, 231) angeordnet sind.

2. Schirmungsmodul nach Anspruch 1,
**dadurch gekennzeichnet,**
daß das verzinkte Stahlblech eine Dicke von 2 mm besitzt.

3. Schirmungsmodul nach Anspruch 1 oder 2,
**dadurch gekennzeichnet,**
daß der Verbindungsbereich (V, 601, 612, 613, 622, 623, 631) eine Breite von 50 mm aufweist.

4. Schirmungsmodul nach einem der Ansprüche 1 - 3,
**dadurch gekennzeichnet,**
daß der verkürzte U-Schenkel (220, 221, 614, 615) eine Breite von 15 mm besitzt.

5. Schirmungsmodul nach einem der Ansprüche 1 - 4,
**dadurch gekennzeichnet,**
daß im Verbindungsbereich (V, 601, 612, 613, 622, 623, 631) eine Lochteilung mit 75 mm Rastermaß (R) mit einem Einstiegsmaß (E) von 37 mm angeordnet ist.

6. Schirmungsmodul nach einem der Ansprüche 1 - 5,
**dadurch gekennzeichnet,**
daß er für eine Eckenanbindung Eckfelder aufweist, die um das Maß (K) für den Verbindungsbereich (410, 420) verbreitert sind.

7. Verfahren zum Herstellen einer geschirmten Kabine unter Verwendung von Schirmungsmodulen nach einem der Ansprüche 1-6, **dadurch gekennzeichnet,**
daß zur hochfrequenten Abdichtung von Verbindungsfugen (260, 606, 626, 636, 730, 950, 1060, 1240) Mesh-Dichtungselemente (270, 500, 607, 617, 627, 740, 960, 961, 1070, 1071, 1250) angeordnet werden.

8. Verfahren nach Anspruch 7, **gekennzeichnet** durch die Verwendung von Mesh-Dichtungselementen (500) aus zwei vollmetallischen gewebten Dichtschnüren (510, 520), die mittels eines Drahtgeflechts (530) miteinander verbunden sind.

9. Verfahren nach Anspruch 8, **gekennzeichnet** durch die Verwendung von Dichtschnüren (510, 520), die einen Durchmesser (D) von 2 - 4 mm besitzen und in einem Abstand (A) von 25 mm angeordnet werden.

10. Verfahren nach einem der Ansprüche 7 - 9,
**dadurch gekennzeichnet,**
daß im Eckenbereich separate Eckmodule angeordnet werden.

11. Verfahren nach einem der Ansprüche 7 - 10,
**dadurch gekennzeichnet,**
daß im Verbindungsbereich, vorzugsweise im Moduleckenbereich, Verstärkungselemente (1230, 1350, 1351, 1352, 1353, 1354, 1355, 1356) angeordnet werden.

12. Verfahren nach einem der Ansprüche 7 - 11,
**dadurch gekennzeichnet,**
daß zur Verschraubung verzinkte Sperrzahnschrauben und/oder Schneidschrauben, vorzugsweise M10 verwendet werden.

13. Verfahren nach einem der Ansprüche 7 - 12,
**dadurch gekennzeichnet,**
daß in einzelnen Schirmungsmodulen (11, 12, 13, 14, 15, 16, 17, 18) Türen (19), Fenster, Wabenkamine (1080, 1160), Filter (800, 910) Rohrduchführungen (1000, 1100), Platteneinsätze (700) u. dgl. hochfrequenzdicht angeordnet werden.

14. Verfahren nach einem der Ansprüche 7 - 13,
**dadurch gekennzeichnet,**
daß vor dem Zusammenbau der einzelnen Schirmungsmodule (1400) das Dichtungsmaterial (1430) mit Hilfe von Haltestopseln (1440) im Verbindungsbereich fixiert wird.

## Claims

1. Screening module made of galvanized steel sheet for a screened cabin (1) of modular construction, which cabin (1) is composed of individual, prefabricated screening modules (210, 211, 600, 610, 620, 630) which are screwed to one another such that they are proof against radio frequency, the screening module (210, 211, 600, 610, 620, 630) having the shape of a U in the connecting region (V, 601, 612, 613, 622, 623, 631), one limb (220, 221, 614, 615) of which U is shortened, characterized in that the connecting region (V, 601; 612, 622, 623, 631) is integrally formed on the screening module, and in that holes (230, 231) are arranged in the shortened U-limb (220, 221).

2. Screening module according to Claim 1, characterized in that the galvanized steel sheet has a thickness of 2 mm.

3. Screening module according to Claim 1 or 2, characterized in that the connecting region (V, 601, 612, 613, 622, 623, 631) has a width of 50 mm.

4. Screening module according to one of Claims 1 - 3, characterized in that the shortened U-limb (220, 221, 614, 615) has a width of 15 mm.

5. Screening module according to one of Claims 1 - 4, characterized in that a hole pitch having a grid size (R) of 75 mm with a lead-in size (E) of 37 mm) is arranged in the connecting region (V, 601, 612, 613, 622, 623, 631).

6. Screening module according to one of Claims 1 - 5, characterized in that said screening module has corner areas for a corner attachment, which corner areas are broadened by the size (K) for the connecting region (410, 420).

7. Method for the production of a screened cabin using screening modules according to one of Claims 1 - 6, characterized in that mesh sealing elements (270, 500, 607, 617, 627, 740, 960, 961, 1070, 1071, 1250) are arranged for radio-frequency proofing of connecting joints (260, 606, 626, 636, 730, 950, 1060, 1240).

8. Method according to Claim 7, characterized by the use of mesh sealing elements (500) composed of two fully metallic woven sealing strips (510, 520) which are connected to one another by means of a wire mesh (530).

9. Method according to Claim 8, characterized by the use of sealing strips (510, 520) which have a diameter (D) of 2 - 4 mm and are arranged at a distance (A) of 25 mm.

10. Method according to one of Claims 7 - 9, characterized in that separate corner modules are arranged in the corner region.

11. Method according to one of Claims 7 - 10, characterized in that reinforcing elements (1230, 1350, 1351, 1352, 1353, 1354, 1355, 1356) are arranged in the connecting region, preferably in the module corner region.

12. Method according to one of Claims 7 - 11, characterized in that galvanized self-locking screws and/or self-tapping screws, preferably M10, are used for the screw connection.

13. Method according to one of Claims 7 - 12, characterized in that doors (19), windows, honeycomb ducts (1080, 1160), filters (800, 910), pipe bushings (1000, 1100), plate inserts (700) and the like are arranged in a radio-frequency-proof manner in individual screening modules (11, 12, 13, 14, 15, 16, 17, 18).

14. Method according to one of Claims 7 - 13, characterized in that the sealing material (1430) is fixed in the connecting region with the aid of retaining plugs (1440) before the assembly of the individual screening modules (1400).

## Revendications

1. Module de blindage en tôle d'acier étamé pour une cabine blindée (1) de type modulaire, qui est constituée de modules de blindage préfabriqués (210,211,600, 610,620,630), qui sont réunis par vissage d'une manière étanche aux hautes fréquences, le module de blindage (210,211,600,610,620,630) possédant, dans la zone de jonction (V,601,612,613,622,623,631), la forme d'un U, dont une branche (220,221,614,615) est raccourcie, caractérisé par le fait que la zone de jonction (V 601,612,622,623,631) est formée d'un seul tenant sur le module de blindage et que des perçages (230,231) sont ménagés dans la branche raccourcie (220,221) du U.

2. Module de blindage suivant la revendication 1, caractérisé par le fait que la tôle d'acier étamé a une épaisseur de 2 mm.

3. Module de blindage suivant la revendication 1 ou 2, caractérisé par le fait que la zone de jonction (V,601, 612,613,622,623,631) a une largeur de 50 mm.

4. Module de blindage suivant l'une des revendications 1 à 3, caractérisé par le fait que la branche raccourcie (201,221,614,615) du U a une largeur de 15 mm.

5. Module de blindage suivant l'une des revendications 1 à 4, caractérisé par le fait qu'un ensemble de trous répartis selon un pas de réseau (R) de 75 mm et avec une distance (E) par rapport au bord de 37 mm est prévu dans la zone de jonction (V, 601,612,613,622,623,631).

6. Module de blindage suivant l'une des revendications 1 à 5, caractérisé par le fait qu'il possède, pour une liaison d'angle, des parties d'angle qui sont élargies, de la valeur (K), pour la zone de jonction (410, 420).

7. Procédé pour fabriquer une cabine blindée moyennant l'utilisation de modules de blindage suivant l'une des revendications 1 à 6, caractérisé par le fait que pour l'étanchéité aux hautes fréquences de joints de liaison (260, 606,626,636,730,950,1060,1240), il est prévu des éléments de treillis d'étanchéité (270,500,607,617, 627,740,960,961, 1070,1071,1250).

8. Procédé suivant la revendication 7, caractérisé par l'utilisation d'éléments de treillis d'étanchéité (500) formés de deux cordons d'étanchéité entièrement métalliques tissés (510,520), qui sont réunis entre eux au moyen d'un treillis de fils (530).

9. Procédé suivant la revendication 8, caractérisé par l'utilisation de cordons d'étanchéité (510,520) qui ont un diamètre (D) de 2 à 4 mm et sont à une distance (A) de 25 mm.

10. Procédé suivant l'une des revendications 7 à 9, caractérisé par le fait que des modules d'angle distincts sont prévus dans la zone d'angle.

11. Procédé suivant l'une des revendications 7 à 10, caractérisé par le fait que des éléments de renforcement (1230,1350,1351,1352,1353,1354,1355,1356) sont disposés dans la zone de jonction, de préférence dans la zone d'angle du module.

12. Procédé suivant l'une des revendications 7 à 11, caractérisé par le fait que pour le vissage, on utilise des vis étamées à dents de blocage et/ou des vis autotaraudeuses, de préférence M10.

13. Procédé suivant l'une des revendications 7 à 12, caractérisé par le fait que dans des modules individuels de blindage (11,12,13,14,15,16,17,18) sont disposées, d'une manière étanche aux hautes fréquences, des portes (19), des fenêtres, des cheminées en nids d'abeilles (1080, 1160), des filtres (800,910), des traversées tubulaires (1000, 1100), des plaques rapportées (700) ou analogues.

14. Procédé suivant l'une des revendications 7 à 13, caractérisé par le fait qu'avant l'assemblage des différents modules de blindage (1400), le matériau d'étanchéité (1430) est fixé à l'aide de fiches de retenue (1440) dans la zone de jonction.
